# EUROPEAN PATENT SPECIFICATION

(11) **EP 1 426 464 B1**
(45) Date of publication and mention of the grant of the patent: **22.04.2009**
(21) Application number: 02027142.5
(22) Date of filing: 04.12.2002
(51) Int. Cl.: C23C 18/16

(54) **Method for producing metal/ceramic bonding substrate**
Verfahren zur Herstellung eines Metall/Keramik-Verbindungssubstrates
Procédé de fabrication d'une surface de soudage en métal/ceramique

(43) Date of publication of application: 09.06.2004
(73) Proprietor: DOWA METALTECH CO., LTD., Chiyoda-ku Tokyo 101-0021 (JP)
(72) Inventor: Ning, Xiao-Shan, Shiojiri-shi, Nagano 399-0704 (JP); Tsukaguchi, Nobuyoshi, Shiojiri-shi, Nagano 399-0703 (JP); Kimura, Masami, Funabashi-shi, Chiba 274-0063 (JP); Namioka, Kazuhiko, Siojiri-shi, Nagano, 399-0745 (JP); Kitamura, Yukihiro, Shiojiri-shi, Nagano, 399-0703 (JP)
(74) Representative: Manitz, Finsterwald & Partner GbR

(56) References cited:
- US-A- 4 122 215
- PATENT ABSTRACTS OF JAPAN vol. 018, no. 156 (P-1710), 15 March 1994 (1994-03-15) & JP 05 325185 A (C UYEMURA & CO LTD), 10 December 1993 (1993-12-10)
- PATENT ABSTRACTS OF JAPAN vol. 016, no. 076 (C-0914), 25 February 1992 (1992-02-25) & JP 03 267377 A (SEIKO INSTR INC), 28 November 1991 (1991-11-28)
- PATENT ABSTRACTS OF JAPAN vol. 1998, no. 04, 31 March 1998 (1998-03-31) & JP 09 316650 A (FUJITSU LTD), 9 December 1997 (1997-12-09)

## Description

### BACKGROUND OF THE INVENTION

### Field of the Invention

The present invention generally relates to a method for producing a metal/ceramic bonding substrate. More specifically, the invention relates to a method for producing a metal/ceramic bonding substrate on which chip parts for use in a power module or the like are suitably mounted. The present invention also relates to a method for producing a bonding substrate of aluminum or an aluminum alloy and a ceramic, which is mounted on a vehicle or the like required to particularly have high reliability, and more specifically, the invention relates to a method for producing a metal/ceramic bonding substrate wherein portions of aluminum or an aluminum alloy on which chip parts and terminals are to be soldered are plated with nickel.

### Description of the Prior Art

As the materials of electrodes of metal/ceramic bonding substrates for power modules for use in vehicles required to particularly have high reliability, aluminum or aluminum alloys are often used. If aluminum or an aluminum alloy is used as the material of an electrode, anickel electroplating or an electroless plating, such as an Ni-P or Ni-B electroless plating, is generally carried out on the surface of the electrode in order to improve solder and environment resistances of chips and heat sinks. If it is technically difficult or expensive to provide an electrode to be electroplated since a circuit pattern is relatively complicated, an electroless plating is carried out.

As a method for electroless-plating aluminum or an aluminum alloy with a nickel alloy, Japanese Patent Laid-Open No. 5-325185 discloses a zincate conversion process wherein a nickel alloy plating is carried out after carrying out pretreatments for degreasing a substrate, removing oxide films from the surface of the substrate with a strong acid solution, dipping the substrate in nitric acid, forming a zincate conversion film on the surface of the substrate and dipping the substrate in nitric acid again to zincate-convert the substrate. Japanese Patent Laid-Open No. 5-325185 also discloses a method (which will be hereinafter referred to as a palladium activating process") for causing the surface of aluminum or an aluminum alloy to absorb a metal or metal ions, such as palladium or palladium ions, which have autocatalysis characteristics with respect to a nickel alloy electroless plating, as a pretreatment, and for carrying out the nickel alloy electroless plating thereon.

As methods for partially plating aluminum or an aluminum alloy, Japanese Patent Laid-Open No. 3-267377 discloses a palladium activating process which uses an alkali peeling type resist and which uses a neutral degreasing agent for a pretreatment, and Japanese Patent Laid-Open No. 9-316650 discloses a method for carrying out a nickel alloy electroless plating after carrying out a treatment with an alkalescent palladium activating agent to which a chelating agent having an ammonia group is added.

However, since the zincate conversion process uses nitric acid and a strong alkaline zincate conversion treating agent in a plating pretreatment process, alkali peeling type resists are not withstand, so that it is not possible to partially plate predetermined portions.

In addition, as a method for electroless-plating only a predetermined portion of aluminum or an aluminum alloy with a nickel alloy, there is known a method for carrying out a nickel alloy electroless plating after masking an undesired portion with an alkali peeling type resist and carrying out the above described palladium activating pretreatment. In this case, although neutral and/or alkalescent solutions exist during processes, the resistance of the resist is not complete, and the linearity of a pattern deteriorates by broken lines or the like. In addition, it is difficult for plating to be deposited around the resist, so that it is easy to cause a so-called defective plating, due to the elution of the resist into the solution although this is not clear.

### SUMMARY OF THE INVENTION

It is therefore an object of the present invention to eliminate the aforementioned problems and to provide a method for producing a metal/ceramic bonding substrate, the method being capable of improving the linearity of a pattern and preventing the occurrence of defective plating to improve the visual failure of plating and ensure the adhesion of plating.

In order to accomplish the aforementioned and other obj ects, the inventors have diligently studied and found that it is possible to provide a method for producing a metal/ceramic bonding substrate, the method being capable of improving the linearity of a pattern and preventing the occurrence of defective plating to improve the visual failure of plating and ensure the adhesion of plating, by carrying out any one of the following processes (1) through (3) before a nickel alloy electroless plating is carried out in a metal/ceramic bonding substrate producing method for electroless-plating a predetermined portion of the surface of a metal plate of aluminum or an aluminum alloy with a nickel alloy after bonding the metal plate to at least one side of a ceramic plate to form a circuit pattern:
(1) after a solvent peeling type resist is used for electroless-plating the predetermined portion of the surface of the metal plate with a nickel alloy, the resist is peeled off;
(2) after the whole surface of the metal plate is electroless-plated with a nickel alloy, a resist is applied on a portion on which the plating of the nickel alloy is required, and a part of the plating of the nickel alloy on which the resist is not applied is removed with an acidic etchant; and
(3) after an alkali peeling type resist having a predetermined shape is applied on the surface of the metal plate, a part of the surface of the metal plate on which the resist is not applied is pretreated by the palladium activating process using chemicals, all of which are acidic, and then, the part of the surface of the metal plate is electroless-plated with a nickel alloy to peel off the resist.

According to one aspect of the present invention, there is provided a method for producing a metal/ceramic bonding substrate, the method comprising the steps of: bonding a metal plate of aluminum or an aluminum alloy to at least one side of a ceramic substrate to a circuit pattern; applying a solvent peeling type resist having a predetermined shape or an alkali peeling type resist having a predetermined shape on a surface of the metal plate; pre-treating a portion of the surface of the metal plate, on which the resist is not applied, by the zincate conversion process or palladium activating process, when a solvent peeling type resist has been applied, or by the palladium activating process, when an alkali peeling type resist has been applied; and electroless-plating the portion of the surface of the metal plate with a nickel alloy, and thereafter, peeling off the resist, wherein the peeling off is effected by an alkali solution, when an alkali peeling type resist has been applied. If in this method for producing a metal/ceramic bonding substrate a solvent peeling type resist is applied, the peeling type resist is preferably an organic solvent peeling type resist, and the resist is preferably peeled off by an organic solvent. If in this method for producing a metal/ceramic bonding substrate an alkali peeling type resist is applied, preferably all of the chemicals for use in the palladium activating process are acidic chemicals.

According to another aspect of the present invention, there is provided a method for producing a metal/ceramic bonding substrate, the method comprising the steps of: bonding a metal plate of aluminum or an aluminum alloy to at least one side of a ceramic substrate to a circuit pattern; pre-treating the whole surface of the metal plate by the zincate conversion process or palladium activating process; electroless-plating the whole surface of the metal plate with a nickel alloy; applying a resist having a predetermined shape on the plating of the nickel alloy; and etching and removing a portion of the plating of the nickel alloy, on which the resist is not applied, by acid chemicals, and thereafter, peeling off the resist. In this method for producing a metal/ceramic bonding substrate, the resist is preferably an alkali peeling type resist or an organic solvent peeling type resist, and the resist is preferably peeled off by an alkali solvent or an organic solvent.

In these methods for producing a metal/ceramic bonding substrate, the main component of the ceramic substrate is preferably a material selected from the group consisting of alumina, aluminum nitride and silicon nitride, and the aluminum alloy is preferably an alloy selected from the group consisting of aluminum-silicon alloys, aluminum-magnesium alloys and aluminum-magnesium-silicon alloys. In addition, the metal plate is preferably bonded to the ceramic substrate by a molten metal bonding method or abrazing filler metal bonding method. Moreover, degreasing and chemical-polishing agents used at the pretreatment step by the palladium activating process are preferably acidic and do not contain nitric acid. Furthermore, a heat treatment is preferably carried out in order to enhance the adhesion strength of the plating.

In the above described methods for producing a metal/ceramic bonding substrate, the zincate conversion process may be carried out by steps of removing an oxide film from the surface of the metal plate and of causing the metal plate and the substrate to be washed, dipped in nitric acid, washed, zincate-converted and washed, and the palladium activating process may be carried out by steps of causing the metal plate and the substrate to be degreased, washed, chemical-polished, washed, palladium-activated and washed.

### BRIEF DESCRIPTION OF THE DRAWINGS

The present invention will be understood more fully from the detailed description given herebelow and from the accompanying drawings of the preferred embodiments of the invention. However, the drawings are not intended to imply limitation of the invention to a specific embodiment, but are for explanation and understanding only.

In the drawings:
FIGS. 1A through 1E are sectional views showing steps of forming a circuit pattern in Example 1;
FIGS. 2A through 2C are sectional views showing steps of producing a metal/ceramic bonding substrate after forming the circuit pattern in Example 1;
FIGS. 3A through 3D are sectional views showing steps of producing a metal/ceramic bonding substrate after forming a circuit pattern in Example 2; and
FIG. 4A through 4C is sectional views showing steps of producing a metal/ceramic bonding substrate after forming a circuit pattern in Example 3.

### DESCRIPTION OF THE PREFERRED EMBODIMENTS

Referring now to the accompanying drawings, a preferred embodiment of a method for producing a metal/ceramic bonding circuit board according to the present invention will be described below.

In a preferred embodiment of a method for producing a metal/ceramic bonding substrate according to the present invention, a substrate mainly containing alumina, AlN or Si₃N₄ is used as a ceramic substrate, and a metal plate of aluminum or an aluminum alloy is bonded to at least one surface of the substrate. Alumina substrates are characterized by inexpensiveness, AlN substrates are characterized by high thermal conductivity, and Si₃N₄ substrates are characterized by high strength. In view of these characteristics, the material of the substrate can be selected in accordance with the purpose thereof. The reason why the metal plate of aluminum or an aluminum alloy is bonded to the ceramic substrate is that a metal having a low proof stress is used for reducing stress, which is produced in the ceramic substrate at the time of bonding, to produce a substrate which is reliable with respect to thermal shock resistance and so forth.

As a method for bonding a metal plate of aluminum or an aluminum alloy to a ceramic substrate, there may be utilized the molten metal bonding method for melting aluminum or an aluminum alloy to move a ceramic substrate in the molten aluminum or aluminum alloy, or the brazing and soldering method for bonding a metal plate of aluminum or an aluminum alloy to a ceramic substrate via a brazing filler metal of Al-Si or the like.

As an example of a method for forming a circuit pattern after bonding a metal plate of aluminum or an aluminum alloy to a ceramic substrate, there is a method for masking the metal plate with an alkali peeling type resist having a shape of a predetermined circuit pattern, and thereafter, dissolving and removing undesired portions of the metal plate by etching with iron chloride or the like to forma circuit pattern. As other examples of methods for forming a circuit pattern, in the case of the molten bonding method, there may be adopted a method wherein a mold having a shape of a circuit pattern is used for completing the formation of a circuit pattern after bonding so that it is not required to carry out the subsequent patterning process, such as etching, and in the case of the brazing and soldering method, there may be adopted a method for bonding a metal plate having a shape of a circuit pattern to a ceramic substrate via a brazing filler metal so that it is not required to carrying out patterning as an after-treatment process.

The adhesion of the resist may be usually carried out by the screen printing or dry film method, and the resist may be cured by ultraviolet or heat.

With respect to the metal/ceramic bonding substrate on which the formation of the circuit pattern has been thus completed, required portions are plated by the following processes.
(1) In a case where an organic solvent peeling type resist is used:
   An organic solvent peeling type resist is used as a plating masking material for partially carrying out a nickel alloy electroless plating by the zincate conversion process or the palladium activating process,and thereafter,the resist is peeled off by an organic solvent.
   The resist of this type is highly resistant to both of strong alkalis and strong acids, so that most of chemicals other than organic solvents can be used in the plating process. Therefore, it is possible to adopt any pretreatment methods of the zincate conversion process and palladium activating process, and there is no problem with respect to the nickel alloy electroless plating agent. In the peeling of the resist, trichlene or parchlene is generally used as the organic solvent.
(2) In a case where the nickel plating is partially peeled off by after-etching:
   A pretreatment is carried out by the zincate conversion process or the palladium activating process, and the whole surface of the metal plate is electroless-plated with a nickel alloy. Thereafter, for example, an alkali removing type resist is applied on a portion on which the nickel plating is required, and an undesired portion of the nickel plating is dissolved in an iron chloride solution or the like. Finally, the resist is peeled off by using a sodium hydroxide solution as alkali chemicals.
(3) In a case where the palladium activating process is adopted:
   An alkali peeling type resist is applied on the metal plate, and a nickel alloy electroless plating is carried out by the palladium activating process using degreasing, chemical-polishing and activating agents serving as plating pretreatment agents, all of which are acid liquids. Thereafter, the resist is peeled off by using a sodium hydroxide solution as alkali chemicals.

Referring to the accompanying drawings, examples of a method for producing a metal/ceramic bonding substrate according to the present invention will be described below in detail.

### Example 1

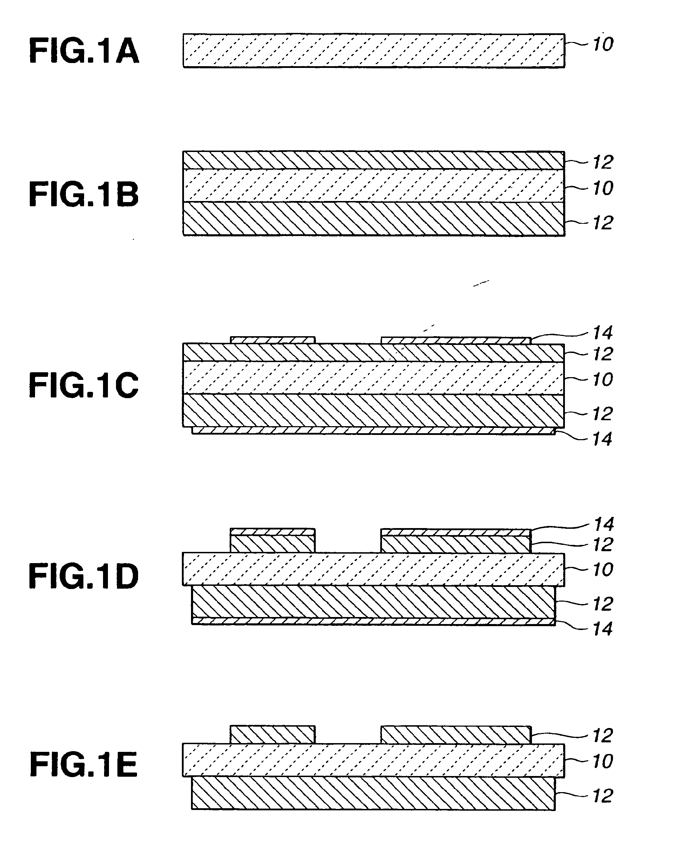

As shown in FIGS. 1A through 1E, after an aluminum nitride (AlN) substrate was prepared as a ceramic substrate 10 (FIG. 1A) and pure aluminum 12 was bonded to the AlN substrate by the molten metal bonding method (FIG. 1B), an alkali removing type resist 14 was printed thereon so as to have a shape of a circuit pattern (FIG. 1C) , and undesired portions of the aluminum 12 were etched and removed with an iron chloride solution (FIG. 1D) to form a circuit (FIG. 1E).

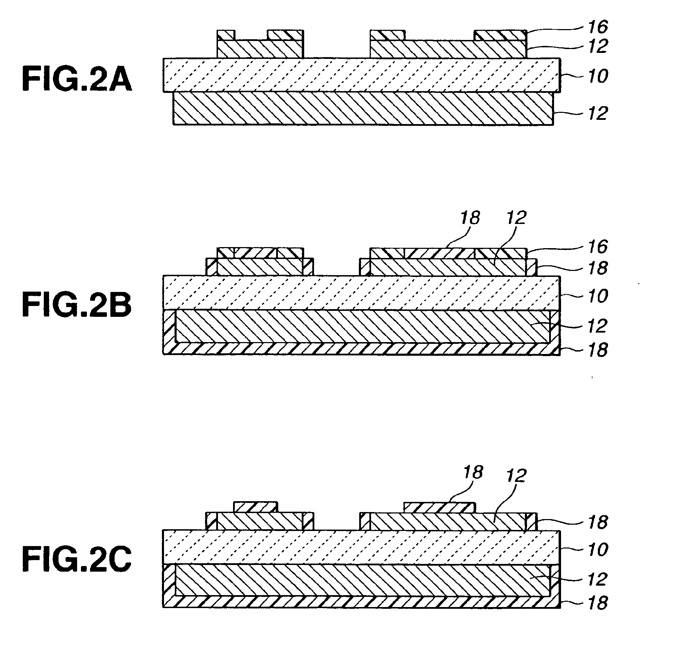

Thereafter, as shown in FIGS. 2A through 2C, in order to plate only predetermined portions, such as portions on which soldering is required, a commercially available resist (M-85K produced by Taiyo Ink Production Co., Ltd.) serving as a solvent peeling type resist 16 was applied on the surface of the aluminum 12 (FIG. 2A). Then, after a pretreatment was carried out by each of the zincate conversion process and palladium activating process, an Ni-P electroless plating 18 having a thickness of about 4 µ m was carried out (FIG. 2B). That is, in the case of the zincate conversion pretreatment process, after an oxide film was removed, the substrate was washed, dipped in nitric acid, washed, zincate-converted, washed, dipped in nitric acid, washed, zincate-converted and washed. After these processes, an Ni-P electroless plating was carried out, and thereafter, the substrate was washed and dried. On the other hand, in the case of the palladium activating pretreatment process, the substrate was degreased, washed, chemical-polished, washed, palladium-activated and washed. After these processes, an Ni-P electroless plating is carried out, and thereafter, the substrate was washed and dried. After the Ni-P electroless plating 18 was carried out, the resist 16 was peeled off by trichlene, and the substrate was washed and dried to obtain samples by the respective pretreatment processes (FIG. 2C).

With respect to these samples, the appearance thereof was checked with the naked eye, and the wire bonding performance, adhesion and solder wettability of the nickel plating were evaluated.

The appearance was evaluated by being classified into a case where the linearity of the line was good, a case where a part of the line eroded, and a case where the resist was peeled off to plate the whole surface (which are shown by "good", "mid" and "bad", respectively, in Table which will be described later) . As a result, in this example, the linearity of the line was good.

With respect to the wire bonding performance, after an aluminum wire having a diameter of 0.3 mm was bonded to the surface of the nickel plating in a loop shape by an ultrasonic wire bonder (USW-20ZDE60S-C produced by Ultrasonic Kogyo Co., Ltd.) on the ultrasonic conditions that the load was 440 g, the time was 0.5 seconds and the output was 7.0, the top of the loop was pulled, and the load was measured when the aluminum wire was cut. As a result, in this example, all of the samples had a sufficient strength of 500 g or more.

The adhesion of the nickel plating was evaluated by being classified into a case where the plating was not peeled off, a case where a part of the plating was peeled off, and a case where the plating was substantially peeled off from the whole surface (which are shown by "good", "mid" and "bad", respectively, in Table which will be described later) , by carrying out tape peeling tests after making lattice-shaped cuts into the nickel plating at intervals of about 1 mm by means of a cutter knife. As a result, in this example, the nickel plating was not peeled off.

It was assumed that the solder wettability was good if an area of 95 % or more was wet when the sample was dipped in an eutectic solder bath at 230 °C for 20 seconds by using a flux, and was no good if the wet area was less than 95 %. As a result, in this example, the solder wettability was good.

### Example 2

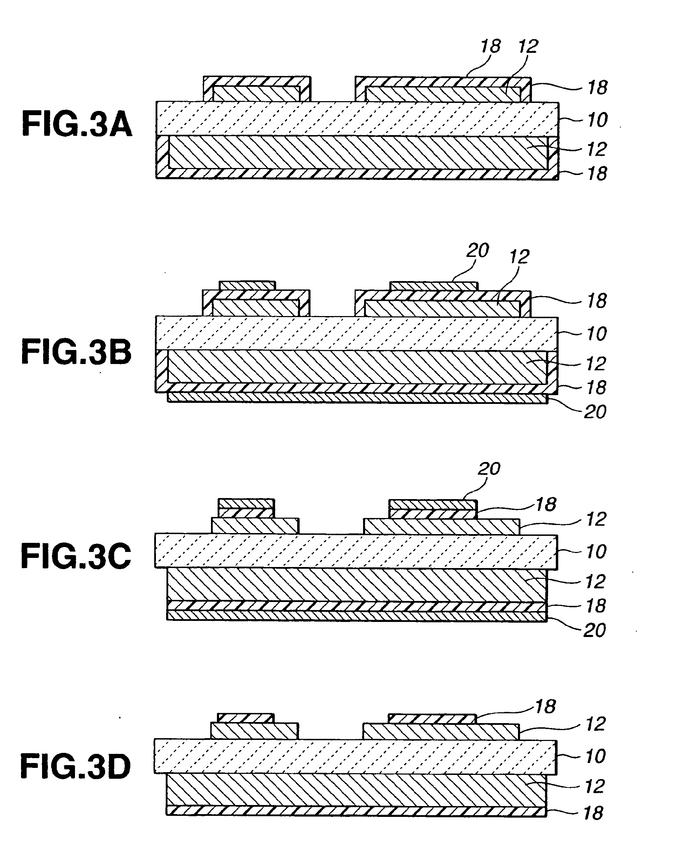

As shown in FIGS. 3A through 3D, two kinds of substrates of AlN and alumina substrates were prepared as ceramic substrates 10 to carry out the steps up to the formation of the circuit by the same method as that in Example 1, to electroless-plate the whole surface of the metal with an Ni-P alloy by each of the same zincate conversion process and palladium activating process as those in Example 1 (FIG. 3A), respectively. Thereafter, alkali peeling type resists 20 were applied by the screen printing only on predetermined portions on which a nickel plating was required (FIG. 3B). Then, undesired portions of the nickel plating were removed by a mixed acid of nitric acid and sulfuric acid to expose the surface of the underlying aluminum to allow an Ni-P plating to be partially carried out (FIG. 3C). Then, after the resists 20 were peeled off by alkali (NaOH) to obtain samples by the same method as that in Example 1 (FIG. 3D).

With respect to these samples, similar to Example 1, the appearance thereof was checked with the naked eye, and the wire bonding performance, adhesion andsolder wettability of the nickel plating were evaluated.

As a result, with respect to the appearance, the linearity of the line was good, and with respect to the wire bonding performance, all of the samples had a sufficient strength of 500 g or more. With respect to the adhesion of the nickel plating, the nickel plating was not peeled off. The solder wettability was good.

### Example 3

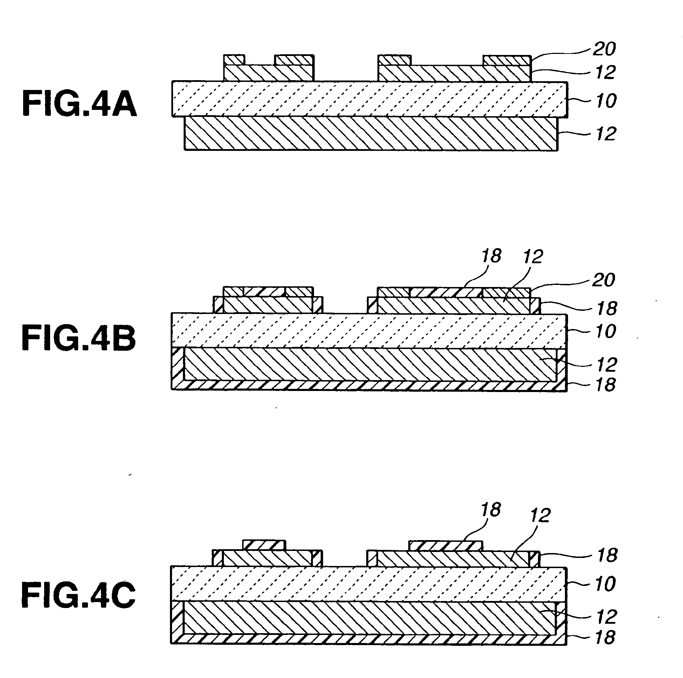

As shown in FIGS. 4A through 4C, two kinds of substrates of AlN and alumina substrates were prepared as ceramic substrates 10, and the steps up to the formation of the circuit were carried out by the same method as that in Example 1, respectively.

Thereafter, in order to plate only predetermined portions, such as portions on which soldering is required, commercially available resists (MT-UV-5203 produced by Mitsui Chemical Co., Ltd.) serving as alkali peeling type resists 20 were applied on the surface of the aluminum 12 by the screen printing (FIG. 4A) . Then, after a pretreatment was carried out by the palladium activating process using chemicals, all of which are acidic, an Ni-P electroless plating 18 was applied (FIG. 4B). As the pretreatment process, the same process as the palladium activation in Example 1 was used. Thereafter, a heat treatment was carried out, and the resists 20 were peeled off by a 3 % solution of sodium hydroxide (FIG. 4C). After neutralization, the substrates were washed and dried to obtain samples, respectively.

With respect to these samples, similar to Example 1, the appearance thereof was checked with the naked eye, and the wire bonding performance, adhesion and solder wettability of the nickel plating were evaluated.

As a result, with respect to the appearance, the linearity of the line was good, and with respect to the wire bonding performance, all of the samples had a sufficient strength of 500 g or more. With respect to the adhesion of the nickel plating, the nickel plating was not peeled off. The solder wettability was good.

### Example 4

Samples were produced by the same method as that in Example 3, except that an AlN substrate was used as a ceramic substrate 10 and an Al-0.5%Si alloy was bonded to the AlN substrate by the molten metal bonding method, and the same evaluation as that in Example 1 was carried out.

As a result, with respect to the appearance, the linearity of the line was good, and with respect to the wire bonding performance, all of the samples had a sufficient strength of 500 g or more. With respect to the adhesion of the nickel plating, the nickel plating was not peeled off. The solder wettability was good.

### Example 5

Samples were produced by the same method as that in Example 3, except that an AlN substrate was used as a ceramic substrate 10 and pure aluminum was bonded to the AlN substrate by means of anAl-Si brazing filler metal, and the same evaluation as that in Example 1 was carried out.

As a result, with respect to the appearance, the linearity of the line was good, and with respect to the wire bonding performance, all of the samples had a sufficient strength of 500 g or more. With respect to the adhesion of the nickel plating, the nickel plating was not peeled off. The solder wettability was good.

### Example 6

Samples were produced by the same method as that in Example 3, except that an AlN substrate was used as a ceramic substrate 10 and an Al-Mg-Si alloy corresponding to JIS6061 was bonded to the AlN substrate by means of an Al-Si brazing filler metal, and the same evaluation as that in Example 1 was carried out.

As a result, with respect to the appearance, the linearity of the line was good, and with respect to the wire bonding performance, all of the samples had a sufficient strength of 500 g or more. With respect to the adhesion of the nickel plating, the nickel plating was not peeled off. The solder wettability was good.

### Comparative Example 1

An Ni-P electroless plating was attempted to be carried out by the same method as that in Example 3, except that a pretreatment was carried out by the zincate conversion process. However, in a chemical polishing process with nitric acid, all of the resists were peeled off, so that it was not possible to carry out the partial plating.

### Comparative Example 2

An Ni-P electroless plating was attempted to be carried out by the same method as that in Example 3, except that a commercially available alkali degreasing agent was used. However, the resists were peeled off, so that it was not possible to carry out the partial plating.

### Comparative Example 3

Samples were produced by the same method as that in Example 3, except that the same alkali degreasing agent as that in Comparative Example 2 was neutralized with acid to be neutral, and the same evaluation as that in Example 1 was carried out.

As a result, with respect to the appearance, a part of the line eroded, and with respect to the wire bonding performance, all of the samples had only a strength of 300 g or more (although a strength of 450 g or more was required as good conditions, all of the samples did not have such a strength). With respect to the adhesion of the nickel plating, a part of the nickel plating was peeled off. However, the solder wettability was good.

The results inExamples 1 through 6 and Comparative Examples 1 through 3 are shown in the following Table.

**Table**

| | Plating Pretreatment | Ceramic | Appearance | Wire Bonding | Adhesion | Solder Wettability |
|---|---|---|---|---|---|---|
| Ex.1 | zincate | AlN | good | >500g | good | good |
| | Pd | AlN | good | >500g | good | good |
| | | | | | | |
| Ex.2 | zincate | alumina | good | >500g | good | good |
| | Pd | alumina | good | >500g | good | good |
| | Zincate | AlN | good | >500g | good | good |
| | Pd | AlN | good | >500g | good | good |
| | | | | | | |
| Ex.3 | Pd | alumina | good | >500g | good | good |
| | Pd | AlN | good | >500g | good | good |
| | | | | | | |
| Ex.4 | Pd | AlN | good | >500g | good | good |
| | | | | | | |
| Ex.5 | Pd | AlN | good | >500g | good | good |
| | | | | | | |
| Ex.6 | Pd | AlN | good | >500g | good | good |
| | | | | | | |
| Comp.1 | zincate | alumina | bad | --- | --- | --- |
| | zincate | AlN | bad | --- | --- | --- |
| | | | | | | |
| Comp.2 | Pd | AlN | bad | --- | --- | --- |
| | | | | | | |
| Comp.3 | Pd | AlN | mid | >300g | mid | good |

As described above, according to the present invention, it is possible to provide a method for producing a metal/ceramic bonding substrate, which has excellent characteristic and on which a nickel plating is partially applied, the method being capable of improving the linearity of a pattern and preventing the occurrence of defective plating to improve the visual failure of plating and ensure the adhesion of plating, by carrying out any one of the following processes (1) through (3) before a nickel alloy electroless plating is carried out in a metal/ceramic bonding substrate producing method for electroless-plating a predetermined portion of the surface of a metal plate of aluminum or an aluminum alloy with a nickel alloy after bonding the metal plate to at least one side of a ceramic plate to form a circuit pattern:
(1) after a solvent peeling type resist is used for electroless-plating the predetermined portion of the surface of the metal plate with a nickel alloy, the resist is peeled off;
(2) after the whole surface of the metal plate is electroless-plated with a nickel alloy, a resist is applied on a portion on which the plating of the nickel alloy is required, and a part of the plating of the nickel alloy on which the resist is not applied is removed with an acidic etchant; and
(3) after an alkali peeling type resist having a predetermined shape is applied on the surface of the metal plate, a part of the surface of the metal plate on which the resist is not applied is pretreated by the palladium activating process using chemicals, all of which are acidic, and then, the part of the surface of the metal plate is electroless-plated with a nickel alloy to peel off the resist.

Furthermore, since facilities and handling of chemicals to be used are different in each producing section, the industrially most advantageous method may be selected from the above described three methods (1) through (3) in view of costs and safety.

## Claims

1. A method for producing a metal/ceramic bonding substrate, the method comprising the steps of:
bonding a metal plate of aluminum or an aluminum alloy to at least one side of a ceramic substrate to a circuit pattern;
applying a solvent peeling type resist having a predetermined shape or an alkali peeling type resist having a predetermined shape on a surface of said metal plate;
pre-treating a portion of the surface of said metal plate, on which said resist is not applied, by the zincate conversion process or palladium activating process, when a solvent peeling type resist has been applied, or by the palladium activating process, when an alkali peeling type resist has been applied; and
electroless-plating said portion of the surface of said metal plate with a nickel alloy, and thereafter, peeling off said resist, wherein the peeling off is effected by an alkali solution, when an alkali peeling type resist has been applied.

2. A method for producing a metal/ceramic bonding substrate as set forth in claim 1, wherein said solvent peeling type resist is an organic solvent peeling type resist, and said resist is peeled off by an organic solvent.

3. A method for producing a metal/ceramic bonding substrate as set forth in claim 1, wherein an alkali peeling type resist is applied and wherein all of chemicals for use in said palladium activating process are acidic chemicals.

4. A method for producing a metal/ ceramic bonding substrate, the method comprising the steps of:
bonding a metal plate of aluminum or an aluminum alloy to at least one side of a ceramic substrate to a circuit pattern;
pre-treating the whole surface of said metal plate by the zincate conversion process or palladium activating process;
electroless-plating said whole surface of said metal plate with a nickel alloy;
applying a resist having a predetermined shape on the plating of said nickel alloy; and
etching and removing a portion of the plating of said nickel alloy, on which said resist is not applied, by acid chemicals, and thereafter, peeling off said resist.

5. A method for producing a metal/ceramic bonding substrate as set forth in claim 4, wherein said resist is an alkali peeling type resist, and said resist is peeled off by an alkali solvent.

6. A method for producing a metal/ceramic bonding substrate as set forth in claim 4, wherein said resist is an organic solvent peeling type resist, and said resist is peeled off by an organic solvent.

7. A method for producing a metal/ceramic bonding substrate as set forth in any one of claims 1 through 6, wherein said ceramic substrate mainly contains a material selected from the group consisting of alumina, aluminum nitride and silicon nitride.

8. A method for producing a metal/ ceramic bonding substrate as set forth in any one of claims 1 through 6, wherein said aluminum alloy is an alloy selected from the group consisting of aluminum-silicon alloys, aluminum-magnesium alloys and aluminum-magnesium-silicon alloys.

9. A method for producing a metal/ceramic bonding substrate as set forth in any one of claims 1- through 6, wherein said metal plate is bonded to said ceramic substrate by a molten metal bonding method or a brazing filler metal bonding method.

10. A method for producing a metal/ceramic bonding substrate as set forth in any one of claims 1 through 6, wherein degreasing and chemical-polishing agents used at said pretreatment step by said palladium activating process are acidic and do not contain nitric acid.

11. A method for producing a metal/ceramic bonding substrate as set forth in any one of claims 1, 2, 4, 5 or 6, wherein said zincate conversion process is carried out by steps of removing an oxide film from the surface of said metal plate and of causing said metal plate and said substrate to be washed, dipped in nitric acid, washed, zincate-conversed and washed.

12. A method for producing a metal/ceramic bonding substrate as set forth in any one of claims 1 through 6, wherein said palladium activating process is carried out by steps of causing said metal plate and said substrate to be degreased, washed, chemical-polished, washed, palladium-activated and washed.

## Patentansprüche

1. Verfahren zum Herstellen eines Metall-/Keramik-Verbundsubstrates, wobei das Verfahren die Schritte umfasst:
Verbinden einer Metallplatte aus Aluminium oder einer Aluminiumlegierung mit wenigstens einer Seite eines Keramiksubstrates zu einem Schaltungsmuster,
Aufbringen eines Abdeckmittels vom Lösungsmittelablösungstyp mit einer vorausgewählten Form oder eines Abdeckmittels vom Alkaliablösungstyp mit einer vorausgewählten Form auf eine Oberfläche der Metallplatte,
Vorbehandeln eines Teilstücks der Oberfläche der Metallplatte, auf das das Abdeckmittel nicht aufgebracht worden ist, durch das Zinkatumsetzungsverfahren oder das Palladiumaktivierungsverfahren, wenn ein Abdeckmittel vom Lösungsmittelablösungstyp aufgebracht worden ist, oder durch das Palladiumaktivierungsverfahren, wenn ein Abdeckmittel vom Alkaliablösungstyp aufgebracht worden ist, und
stromloses Plattieren des Teilstücks der Oberfläche der Metallplatte mit einer Nickelplattierung und anschließend Ablösen des Abdeckmittels, wobei das Ablösen durch eine Alkalilösung bewirkt wird, wenn ein Abdeckmittel vom Alkaliablösungstyp aufgebracht worden ist.

2. Verfahren zum Herstellen eines Metall-/Keramik-Verbundsubstrates nach Anspruch 1, wobei das Abdeckmittel vom Lösemittelablösungstyp ein Abdeckmittel vom organischen Lösungsmittelablösungstyps ist und das Abdeckmittel durch ein organisches Lösungsmittel abgelöst wird.

3. Verfahren zum Herstellen eines Metall-/Keramik-Verbundsubstrates nach Anspruch 1, wobei ein Abdeckmittel vom Alkaliablösungstyp aufgebracht wird, und, wobei alle Chemikalien zur Verwendung in dem Palladiumaktivierungsverfahren saure Chemikalien sind.

4. Verfahren zum Herstellen eines Metall-/Keramik-Verbundsubstrates, wobei das Verfahren die Schritte umfasst:
Verbinden einer Metallplatte aus Aluminium oder einer Aluminiumlegierung mit wenigstens einer Seite eines Keramiksubstrats zu einem Schaltungsmuster,
Vorbehandeln der gesamten Oberfläche der Metallplatte durch das Zinkatumsetzungsverfahren oder das Palladiumaktivierungsverfahren,
stromloses Plattieren der gesamten Oberfläche der Metallplatte mit einer Nickellegierung,
Aufbringen eines Abdeckmittels mit einer vorausgewählten Form auf die Plattierung aus der Nickellegierung und
Ätzen und Entfernen eines Teilstücks der Plattierung der Nickellegierung, auf dem das Abdeckmittel nicht aufgebracht worden ist, durch saure Chemikalien und nachfolgend Ablösen des Abdeckmittels.

5. Verfahren zum Herstellen eines Metall-/ Keramik-Verbundsubstrates nach Anspruch 4, wobei das Abdeckmittel ein Abdeckmittel vom Alkaliablösungstyp ist, und, wobei das Abdeckmittel durch ein alkalisches Lösungsmittel abgelöst wird.

6. Verfahren zum Herstellen eines Metall-/Keramik-Verbundsubstrates nach Anspruch 4, wobei das Abdeckmittel ein Abdeckmittel vom organischen Lösungsmittelablösungstyp ist, und, wobei das Abdeckmittel durch ein organisches Lösungsmittel abgelöst wird.

7. Verfahren zum Herstellen eines Metall-/Keramik-Verbundsubstrates nach einem der Ansprüche 1 bis 6, wobei das Keramiksubstrat hauptsächlich ein Material ausgewählt aus der Gruppe bestehend aus Aluminiumoxid, Aluminiumnitrid und Siliziumnitrid enthält.

8. Verfahren zum Herstellen eines Metall-/Keramik-Verbundsubstrates nach einem der Ansprüche 1 bis 6, wobei die Aluminiumlegierung eine Legierung ist, welche aus der Gruppe ausgewählt wird, welche aus Aluminium-Silizium-Legierungen, Aluminium-Magnesium-Legierungen und Aluminium-Magnesium-Siliziumlegierungen besteht.

9. Verfahren zum Herstellen eines Metall-/Keramik-Verbundsubstrates nach einem der Ansprüche 1 bis 6, wobei die Metallplatte an das Keramiksubstrat durch ein Metallschmelzeverbindungsverfahren oder durch ein Hartlötmetallverbindungsverfahren gebunden wird.

10. Verfahren zum Herstellen eines Metall-/Keramik-Verbundsubstrates nach einem der Ansprüche 1 bis 6, wobei die Entfettungs- und chemischen Poliermittel, welche in dem Vorbehandlungsschritt durch das Palladiumaktivierungsverfahren eingesetzt werden, sauer sind und keine Salpetersäure enthalten.

11. Verfahren zum Herstellen eines Metall-/Keramik-Verbundsubstrates nach einem der Ansprüche 1, 2, 4, 5 oder 6, wobei das Zinkatumsetzungsverfahren durchgeführt wird mit den Schritten: Entfernen eines Oxidfilms von der Oberfläche der Metallplatte und Waschen, Eintauchen in Salpetersäure, Waschen, Zinkatumsetzung und Waschen der Metallplatte und des Substrats.

12. Verfahren zum Herstellen eines Metall-/Keramik-Verbundsubstrates nach einem der Ansprüche 1 bis 6, wobei das Palladiumaktivierungsverfahren durchgeführt wird durch die Schritte: Entfetten, Waschen, chemisches Polieren, Waschen, Palladiumaktivieren und Waschen der Metallplatte und des Substrats.

## Revendications

1. Procédé pour la production d'un substrat à liaison métal/matière céramique, procédé comprenant les étapes consistant :
à lier une plaque métallique d'aluminium ou d'un alliage d'aluminium à au moins une face d'un substrat en matière céramique pour former un motif de circuit ;
à appliquer un résist du type pouvant être éliminé par un solvant, ayant une forme prédéterminée, ou un résist du type pouvant être éliminé par un agent alcalin, ayant une forme prédéterminée, sur une surface de ladite plaque métallique ;
à prétraiter une partie de la surface de ladite plaque métallique, sur laquelle ledit résist n'est pas appliqué, par le procédé de conversion de zincate ou le procédé d'activation au palladium, lorsqu'un résist du type pouvant être éliminé par un solvant a été appliqué, ou par le procédé d'activation au palladium, lorsqu'un résist du type pouvant être éliminé par un agent alcalin a été appliqué ; et
à effectuer le plaquage autocatalytique de ladite partie de la surface de ladite plaque métallique avec un alliage de nickel et ensuite, à éliminer ledit résist, ladite élimination étant effectuée par une solution d'un agent alcalin, lorsqu'un résist du type pouvant être éliminé par un agent alcalin a été appliqué.

2. Procédé pour la production de substrat à liaison métal/matière céramique suivant la revendication 1, dans lequel ledit résist du type pouvant être éliminé par un solvant est un résist du type pouvant être éliminé par un solvant organique, et ledit résist est éliminé par un solvant organique.

3. Procédé pour la production de substrat à liaison métal/matière céramique suivant la revendication 1, dans lequel un résist du type pouvant être éliminé par un agent alcalin est appliqué et dans lequel tous les agents chimiques destinés à être utilisés dans ledit procédé d'activation au palladium sont des agents chimiques acides.

4. Procédé pour la production de substrat à liaison métal/matière céramique, le procédé comprenant les étapes consistant .
à lier une plaque métallique d'aluminium ou d'un alliage d'aluminium à au moins une face d'un substrat en matière céramique pour la formation d'un motif de circuit ;
à prétraiter la surface totale de ladite plaque métallique par le procédé de conversion de zincate ou le procédé d'activation au palladium ;
à effectuer le plaquage autocatalytique de ladite surface totale de ladite plaque métallique avec un alliage de nickel ;
à appliquer un résist ayant une forme prédéterminée sur le plaquage dudit alliage de nickel ; et
à attaquer et éliminer une partie du plaquage dudit alliage de nickel, sur lequel ledit résist n'est pas appliqué, par des agents chimiques acides et ensuite à éliminer ledit résist.

5. Procédé pour la production de substrat à liaison métal/matière céramique suivant la revendication 4, dans lequel ledit résist est un résist du type pouvant être éliminé par un agent alcalin, et ledit résist est éliminé par un solvant alcalin.

6. Procédé pour la production de substrat à liaison métal/matière céramique suivant la revendication 4, dans lequel ledit résist est un résist du type pouvant être éliminé par un solvant organique et ledit résist est éliminé par un solvant organique.

7. Procédé pour la production de substrat à liaison métal/matière céramique suivant l'une quelconque des revendications 1 à 6, dans lequel ledit substrat en matière céramique contient principalement une matière choisie dans le groupe consistant en l'alumine, le nitrure d'aluminium et le nitrure de silicium.

8. Procédé pour la production d'un substrat à liaison métal/matière céramique suivant l'une quelconque des revendications 1 à 6, dans lequel ledit alliage d'aluminium est un alliage choisi dans le groupe consistant en des alliages aluminium-silicium, des alliages aluminium-magnésium et des alliages aluminium-magnésium-silicium.

9. Procédé pour la production de substrat à liaison métal/matière céramique suivant l'une quelconque des revendications 1 à 6, dans lequel ladite plaque métallique est liée audit substrat en matière céramique par un procédé de liaison par métal fondu ou un procédé de liaison par métal d'apport de brasage.

10. Procédé pour la production de substrat à liaison métal/matière céramique suivant l'une quelconque des revendications 1 à 6, dans lequel des agents dégraissants et agents de polissage chimique utilisés dans ladite étape de prétraitement par le procédé d'activation au palladium sont acides et ne contiennent pas d'acide nitrique.

11. Procédé pour la production de substrat à liaison métal/matière céramique suivant l'une quelconque des revendications 1, 2, 4, 5 ou 6, dans lequel ledit procédé de conversion de zincate est mis en oeuvre par des étapes consistant à éliminer un film d'oxyde de la surface de ladite plaque métallique et à soumettre ladite plaque métallique et ledit substrat à un lavage, une immersion dans de l'acide nitrique, un lavage, une conversion de zincate et un lavage.

12. Procédé pour la production de substrat à liaison métal/matière céramique suivant l'une quelconque des revendications 1 à 6, dans lequel ledit procédé d' activation au palladium est mis en oeuvre par des étapes consistant à soumettre ladite plaque métallique et ledit substrat à un dégraissage, un lavage, un polissage chimique, un lavage, une activation au palladium et un lavage.
